(19) **Europäisches Patentamt**
**European Patent Office**
**Office européen des brevets**

(11) Veröffentlichungsnummer: **0 090 066**
**B1**

(12) **EUROPÄISCHE PATENTSCHRIFT**

(45) Veröffentlichungstag der Patentschrift: **30.05.90**

(51) Int. Cl.⁵: **H 04 N 5/30**

(21) Anmeldenummer: **82102718.2**

(22) Anmeldetag: **31.03.82**

(54) **Festkörper-Fernsehkamera.**

(43) Veröffentlichungstag der Anmeldung:
**05.10.83 Patentblatt 83/40**

(45) Bekanntmachung des Hinweises auf
die Patenterteilung:
**30.05.90 Patentblatt 90/22**

(84) Benannte Vertragsstaaten:
**DE FR GB IT**

(56) Entgegenhaltungen:
**EP-A-0 039 177**
**GB-A-2 000 658**
**US-A-4 009 388**

**PATENTS ABSTRACTS OF JAPAN, Band 3, Nr. 99(E-132), 22. August 1979, Seite 156E132**
**IBM TECHNICAL DISCLOSURE BULLETIN, Band 21, Nr. 2, Juli 1978, Seiten 857-858, New York, USA**
**Tagungsband der 7. Jahrestagung der FKTG vom 17. bis 21. Sept. 1979, Seiten 98-111**

(73) Patentinhaber: **IBM DEUTSCHLAND GMBH**
**Pascalstrasse 100**
**D-7000 Stuttgart 80 (DE)**
(84) **DE**

(73) Patentinhaber: **International Business Machines Corporation**
**Old Orchard Road**
**Armonk, N.Y. 10504 (US)**
(84) **FR GB IT**

(72) Erfinder: **Korth, Hans-Erdmann, Dipl.-Phys.**
**Sandberger Strasse 34**
**D-7000 Stuttgart 1 (DE)**

(74) Vertreter: **Gaugel, Heinz, Dipl.-Ing.**
**IBM Deutschland GmbH Schönaicher Strasse 220**
**D-7030 Böblingen (DE)**

Courier Press, Leamington Spa, England.

**Beschreibung**

Die Erfindung betrifft eine Festkörper-Fernsehkamera mit Halbleiter-Bildaufnehmern, die über je eine Abbildungsoptik fester Brennweite belichtet werden, jeweils aus einer monolithisch integrierten Mikroschaltung bestehen, die Horizontal und Verikalabtastung sowie Ausgangsverstärker enthält, substratgebunden und über Anschlußflächen der Mikroschaltung mit Substrat-Kontaktteilen verbunden sind und denen zur Horizontal- sowie Vertikalabtastung jeweils über weitere, mit entsprechenden Substrat-Kontaktteilen verbundene Anschlußflächen Taktpulse zuführbar sind.

Eine Festkörper-Fernsehkamera ist beispielsweise in dem Artikel von U. Reimers "Farbfernsehkameras mit zwei Halbleiter-Bildsensoren" im Tagungsband der 7. Jahrestagung der FKTG vom 17. — 21. September 1979 in Dortmund beschrieben. Ein Beispiel für einen Halbleiter-Bildaufnehmer in Form einer Matrix aus lichtempfindlichen Sensoren ist in der EP—A—39177 zu finden.

Derartige Kameras sind allein deshalb schon in ihrer Herstellung aufwendig, als die Halbleiter-Bildaufnehmer auch nicht einen Fehler in Bildpunktgröße, also in äußerst winzigen Flächenbereichen, aufweisen dürfen.

Um den Einsatz fehlerhafter Halbleiter-Bildaufnehmer zu vermeiden, ist daher eine mehr oder weniger aufwendige Prüfung dieser Halbleiter-Bildaufnehmer nach ihrer Herstellung erforderlich, wobei sich in aller Regel sehr hohe Ausschußraten ergeben.

Hinzu kommt, daß Festkörper-Fernsehkameras der eingangs beschriebenen Art relativ voluminös sind und zudem noch mechanische Einstellung bzw. Justierung während ihres Betriebs erforderlich machen, so daß hierdurch zusätzlicher Raumbedarf bedingt ist. Zusammenfassend läßt sich also sagen, daß eine mit denkbar einfachem und geringem Aufwand herzustellende sowie zu betreibende und außerdem noch kompakte Fernsehkamera mit möglichst geringen Abmessungen bisher nicht zur Verfügung steht.

Hier will die Erfindung Abhilfe schaffen. Die Erfindung, wie sie in den Ansprüchen gekennzeichnet ist, löst die Aufgabe, eine zuverlässig arbeitende und zu betreibende Festkörper-Fernsehkamera mit kleinsten Abmessungen zu schaffen, die unter minimalem Montageaufwand herzustellen ist und vollkommen elektronisch steuerund einstellbar ist, indem den auf einer einzigen Halbleiterscheibe in linearer oder zweidimensionaler Anordnung angeordneten Halbleiter-Bildaufnehmern jeweils über einem Lichtschacht eine besondere Abbildungsoptik zugeordnet ist, wobei Abbildungsoptiken und in Form eines Lichtschachtrosts vorliegende Lichtschächte in einem optischen Bauteil zusammengefaßt sind. Der Lichtschachtrost übernimmt dabei zusätzlich die Aufgabe einer Gegenlichtblende, um seitliches Streulicht fernzuhalten.

Die durch die Erfindung erreichten Vorteile lassen sich im wesentlichen darin sehen, daß aufgrund der großen Anzahl von Halbleiter-Bildaufnehmern auf einer Halbleiterscheibe und der statistischen Verteilung von fehlerhaften Flächenbereichen der Ausfall einzelner Bildpunkte sich nicht mehr so gravierend wie bisher auswirken kann, da die Wahrscheinlichkeit, daß Bildpunktfehler in allen Halbleiter-Bildaufnehmern an jeweils gleicher Stelle auftreten, praktisch auszuschließen ist. Das bedeutet aber, daß die Endkontrolle bei Fertigung der Halbleiterscheiben für Festkörper-Fernsehkameras diesbezüglich vereinfacht und die Ausschußrate dazu noch gegenüber bisher wesentlich herabgesetzt wird.

Ein weiterer Vorteil ergibt sich daraus, daß eine handliche Fernsehkamera bei möglichst kleinen Abmessungen vorliegt, die mittels eines an die Substrat-Kontaktteile angeschlossenen Steckverbinders über Kabel sowohl mit einer Steuereinheit für die Kameraeinstellung als auch mit Baueinheiten zur Verwertung der Videosignale verbunden werden kann. Alternativ lassen sich auch die Substrat-Kontaktteile über Steckverbindung direkt mit einer Steuereinheit und Videosignalverwertungs-Baueinheiten verbinden, wobei letzteres zum Beispiel aus einem Videosystem mit einem geeigneten Speicher, wie z. B. Videoplatte oder Videomagnetbandkassette, bestehen kann.

Die Abbildungsoptiken lassen sich auch in mehrlinsiger Form zur Behebung von Abbildungsfehlern in einfacher Weise herstellen, und zwar indem sich mehrere Linsenplatten mit ihren jeweiligen Linsen übereinanderliegend in den optischen Bauteil anbringen lassen.

Die im elektronischen Bauteil der Festkörper-Fernsehkamera auf einem Substrat mit den Substrat-Kontaktteilen aufgebrachte Halbleiterscheibe weist neben den Halbleiter-Bildaufnehmern die erforderlichen Leitungszüge auf, die einmal direkt zwischen den Halbleiter-Bildaufnehmern liegend unmittelbar auf der Halbleiterscheibe aufgebracht sein können und zum anderen unter Zwischenlage entsprechender Isolationsschichten in besonderen Metallisierungslagen oberhalb der Halbleiterscheibe vorzusehen sind, wobei transparente Leiterbilder auch oberhalb der Halbleiter-Bildaufnehmer selbst verlaufen können. Zusätzlich lassen sich auch Leiterbilder in Form vergrabener Zonen in der Halbleiterscheibe selbst unterhalb der Halbleiter-Bildaufnehmer unterbringen. All dies ist an sich im einzelnen bekannt, so daß hierauf nicht weiter eingegangen zu werden braucht. Nähere Ausführungen hierzu finden sich z. B. in der Zeitschrift "IEEE Journal of Solid State Circuits", August 1980, Vol. SC—15, Heft 4, als Sonderheft über VLSI-Technik.

Möglichkeiten zum Anbringen von Halbleiterscheiben auf Substraten unter Verbinden der Halbleiter-Anschlußflächen mit entsprechenden Anschlußflächen auf dem jeweiligen Substrat lassen sich z. B. dem Buch "Microelectronics Interconnection and Packaging", Electronics Magazine Books, McGraw Hill Publications Corporation, New York, 1980, Seiten 187 bis 197 entnehmen, wo auch verschiedene Arten von Substrat-Kontaktteilen gezeigt sind, um ein Substrat, wie das der vorliegenden Festkörper-Fernsehkamera, über Steckverbindungen mit Videosystemen verbinden zu können. Um die Herstellung des elektronischen Bauteils zu vereinfachen, könnte in vorteilhafter Weise für das Substrat ein Mehrschicht-Keramikträger vorgesehen werden, der zusätzlich noch Leiterbilder für auf das Substrat aufsteckbare Videosysteme zu deren Steuerung enthalten könnte.

Ausführungsbeispiele für Halbleiter-Bildaufnehmer, die ebenfalls hier nicht im einzelnen beschrieben werden sollen, sind u.a. im Heft "IEEE Transactions on Electron Devices", Febr. 1978, Bd. ED—25, Heft 2, als Sonderausgabe über opto-elektronische Bau- und Schaltungselemente und im Buch "Charge Transfer Devices" von Séquin und Tompsett, erschienen im "Academic Press, Inc."-Verlag 1975, beschrieben. Alle gezeigten Arten von Halbleiter-Bildaufnehmern lassen sich für Ausführungsbeispiele der Erfindung verwenden.

Der optische Bauteil der Festkörper-Fernsehkamera läßt sich im übrigen in vorteilhafter Weise ausgestalten. So kann durch Anbringen eines Filterträgers mit entsprechenden Farbfiltern oberhalb oder unterhalb der Abbildungsoptiken in einfachster Weise eine Farbfernsehkamera realisiert werden. Wird eine zweidimensionale Anordnung von Halbleiter-Bildaufnehmern verwendet, dann ist vorteilhafterweise den einzelnen linearen Anordnungen von Halbleiter-Bildaufnehmern in periodischer Folge je eine Farbe zugeordnet, so daß die Ausgangsleitungen der jeweils betreffenden linearen Anordnungen der Halbleiter-Bildaufnehmer gesammelt zur Ausgabe der Videosignale in den einzelnen Grundfarben dienen.

Weiterhin kann der optische Bauteil ein photochromes Deckglas oder eine elektrochrome ebenso wie elektrochemische Transparentplattenstruktur enthalten, um die auf die Halbleiterscheibe einwirkende Lichtstärke regeln bzw. steuern zu können. Die Einstellung und Steuerung der Festkörper-Fernsehkamera gemäß der Erfindung erfolgt wie gesagt mittels einer an die Substrat-Kontaktteile angeschlossenen elektronischen Steuereinheit. Durch Anlegen entsprechender Spannung an die elektrochrome Transparentplattenstruktur läßt sich die jeweils einwirkende Lichtstärke in einfacher Weise einstellen.

Durch Abschalten bzw. Zuschalten von Halbleiter-Bildaufnehmern der Halbleiterscheibe kann zusätzlich noch die Schärfentiefe eingestellt werden, wobei davon auszugehen ist, daß mit abnehmender Matrixgröße des Feldes der Halbleiter-Bildaufnehmer die Schärfentiefe vergrößert wird.

Die Funktion einer Irisblende läßt sich dadurch realisieren, daß nur die aufgrund der herrschenden Lichtverhältnisse bei Bildaufnahme jeweils benötigte Anzahl von Halbleiter-Bildaufnehmern zur Signalabgabe aufgerufen wird. Hierbei kann dann zur Grobregelung der Lichtempfindlichkeit das bereits erwähnte photochrome Deckglas dienen.

Durch geeignete Taktpuls-Ansteuerung der einzelnen Halbleiter-Bildaufnehmer auf der Halbleiterscheibe läßt sich außerdem eine elektronische Fokussierung herbeiführen, indem die einzelnen Halbleiter-Bildaufnehmer je nach ihrer Lage auf der Halbleiterscheibe durch dementsprechende Modifikation des Abtasteinsatz-Zeitpunktes bei Vertikal- und/oder Horizontalabtastung versetzt abgetastet werden.

Besteht der Halbleiter-Bildaufnehmer nur aus einer einzigen linearen Anordnung der Halbleiter-Bildaufnehmer, dann ist allerdings in Kauf zu nehmen, daß die Schärfentiefe bei vorgegebener Lichtempfindlichkeit in einer Richtung sehr viel größer ist als in der anderen.

Wird die Abtastfrequenz und die Abtastadressierung bei Horizontal- und/oder Vertikalabtastung der Halbleiter-Bildaufnehmer variiert, dann lassen sich in Abhängigkeit davon unterschiedliche Bildgrößen erzielen, was einem unechten Zoom-Effekt entspricht. Vorteilhaft ist dabei, daß dies auch unabhängig für beide Bildkoordinaten durchzuführen ist.

Der Korrekturaufwand für die verwendeten Abbildungsoptiken läßt sich klein halten, auch wenn nur einlinsige Abbildungsoptiken Anwendung finden, da bei Farbfernsehbetrieb jede Linse nur einen Farbbereich zu übertragen braucht und die Bildweite fest vorgegeben ist. Falls erforderlich, kann jedenfalls die Bildweite für jede Grundfarbe unterschiedlich fest eingestellt werden, indem z. B. der Abstand zwischen jeweiliger Abbildungsoptik und zugeordnetem Halbleiter-Bildaufnehmer je nach Grundfarbe unterschiedlich festgelegt wird.

Geometrisches Verzeichnen in Form von Parallaxfehlern durch die Abbildungsoptiken läßt sich weitgehend schon dadurch beheben, daß für die Halbleiter-Bildaufnehmermatrix in erster Näherung ein runder Umfang vorgesehen wird. Wird auf äußerst verzeichnungsfreie Genauigkeit der aufgenommenen Bilder Wert gelegt, dann müßten zur Kompensation der jeweiligen geometrischen Verzeichnung die einzelnen Halbleiter-Bildaufnehmer jeweils photoelektronische Schaltungselemente enthalten, die längs gemäß der anzustrebenden Verzeichnungskompensation gekrümmter Koordinaten angeordnet sind.

Das Gehäuse der Kamera kann so ausgebildet sein, daß sich falls erforderlich eine Konverteroptik vorschalten läßt, die andererseits auch von einem die Festkörper-Fernsehkamera tragenden Geräterahmen einschwenkbar gelagert bzw. hieran drehbar befestigt sein kann.

Es ergeben sich bei vorliegender Festkörper-Fernsehkamera zusammengefaßt also folgende Vorteile:

— Festkörper-Fernsehkamera im wahren Sinne des Wortes ohne bewegliche Teile;

— nahezu wartungsfreier Betrieb unter vollständiger elektronischer Einstellungs- sowie Steuerungsmöglichkeit;

— Verwenden von Halbleiterscheiben, die unter wesentlich herabgesetzter Ausschußrate hergestellt sind;

— Montagevereinfachung;

— nur drei Bauteile erforderlich, nämlich optischer Bauteil, elektronischer Bauteil und Gehäuse.

Die Erfindung wird nun anhand einer Ausführungsbeispielsbeschreibung mit Hilfe unten aufgeführter Zeichnungen näher erläutert.

Es zeigen.

Fig 1 einen Querschnittsausschnitt eines ersten Ausführungsbeispiels der Festkörper-Fernsehkamera gemäß der Erfindung;

Fig. 2 einen Querschnittsausschnitt eines Lichtschachtrosts mit eingelegten Farbfiltern,

Fig. 3 einen Querschnittsausschnitt von zwecks Bereitstellens mehrlinsiger Abbildungsoptiken übereinander angeordneter Linsenplatten,

Fig. 4. einen Ausschnitt aus einem Übersichtsschaltplan einer zweidimensionalen Anordnung der Halbleiter-Bildaufnehmer auf der Halbleiterscheibe,

Fig. 5 eine schematische Draufsicht auf eine Halbleiterscheibe mit hierin angedeuteten Halbleiter-Bildaufnehmern,

Fig. 6 eine Querschnittsdarstellung eines zweiten Ausführungsbeispiels der Festkörper-Fernsehkamera gemäß der Erfindung.

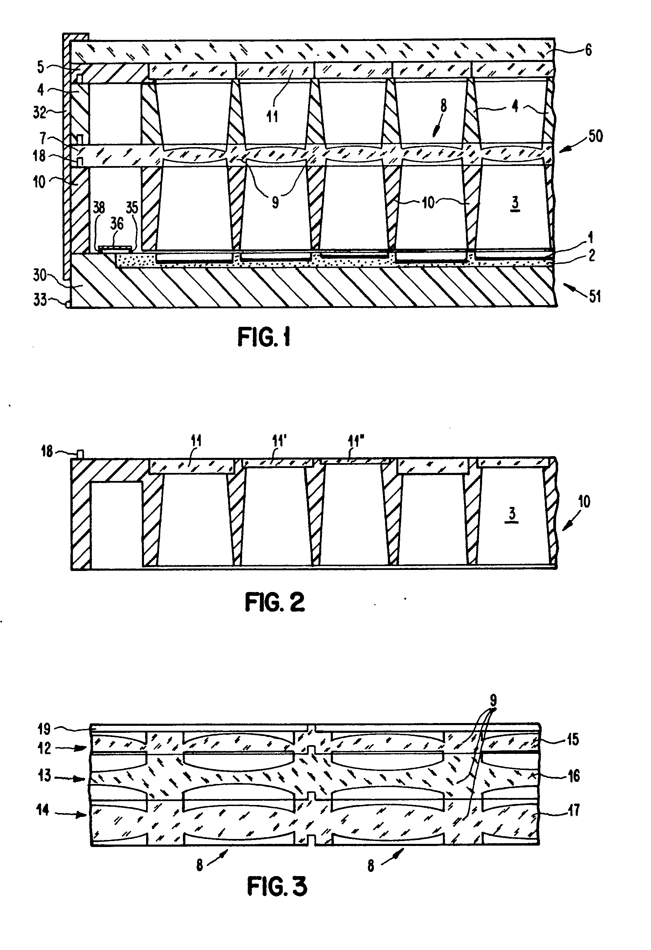

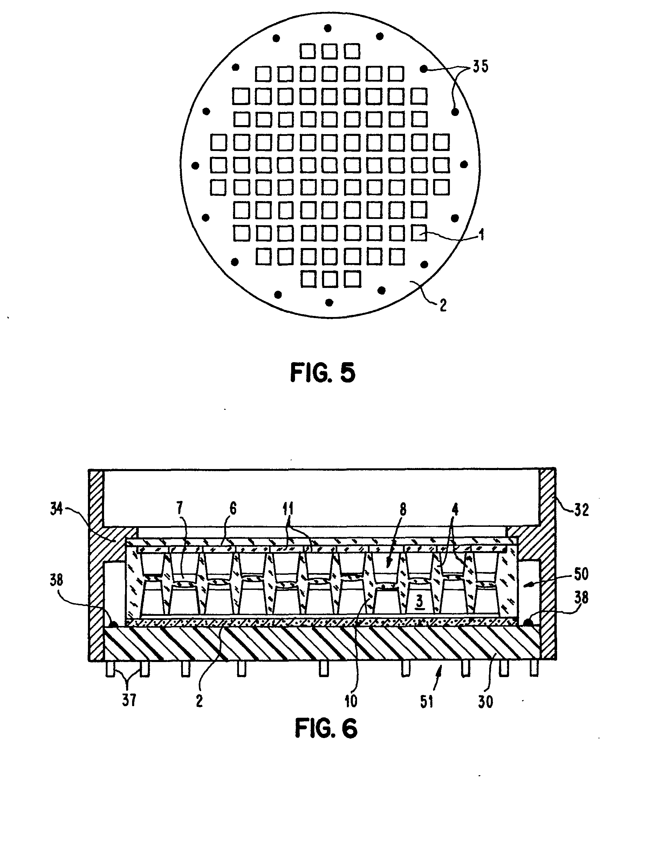

Die mit Fig. 1 gezeigte Festkörper-Fersehkamera kann entweder eine lineare Anordnung von Halbleiter-Bildaufnehmern 1 in einer Halbleiterscheibe 2 oder auch eine zweidimensionale Anordnung von Halbleiter-Bildaufnehmern 1 in der Halbleiterscheibe 2 enthalten. Auf einem isolierenden Substrat 30, wobei hierunter sowohl elektrische Isolation als auch für bestimmte Einsatzbedingungen Wärmeisolation verstanden werden soll, liegt gemäß Fig. 1 eine Halbleiterscheibe 2, in die die Halbleiter-Bildaufnehmer 1 entweder in linearer Anordnung oder zweidimensionaler Anordnung als Matrix eingebracht sind. Die Halbleiterscheibe 2 kann dabei entweder in ein isolierendes Substrat 30 eingelassen sein (Fig. I), oder gemäß einem weiteren Ausführungsbeispiel (Fig. 6) auf dem Substrat 30 aufliegen. Das Substrat 30 kann aus einem Mehrschicht-Keramikträger bestehen, um zum einen die Herstellung von Anschlußverbindungen an die Substrat-Kontaktteile, die aus Randkontakten 33 (Fig. 1), aus Knopfkontakten oder aus Anschlußstiften 37 (Fig. 6) bestehen können, dank hierin übereinanderliegender Leiterbilder gegebenenfalls zu erleichtern und zum anderen bei Bedarf noch Leiterbilder für anzuschließende Steuereinheiten aufnehmen zu können.

Mit Hilfe moderner VLSI-Techniken läßt sich eine relativ große Anzahl von Halbleiter-Bildaufnehmern 1 auf einer Halbleiterscheibe unterbringen, nämlich größenordnungsmäßig 100 (siehe auch: Scientific American, Seiten 67. 68. Januar 1982) Um die für die Koordinatenansteuerung erforderliche Überkreuzungsisolation der einzelnen Leiterbilder zu gewährleisten, lassen sich mehrere voneinander isolierte, die Leiterbilder enthaltende Metallisierungsebenen oberhalb der Halbleiterfläche vorsehen. Um einen freien Lichteinfall auf die Sensorflächen der Halbleiter-Bildaufnehmer zu gewährleisten, müssen zwar in der Regel die sich in den einzelnen Metallisierungsebenen befindenden Leiterbilder ebenfalls zwischen den Halbleiter-Bildaufnehmern 1 verlaufend angebracht sein, jedoch lassen sich aber auch transparente Leiterbilder, die z. B. aus Zinnoxid, Indiumoxid, Thalliumoxid, Cadmiumoxid usw. bestehen können, oberhalb der Lichteinfangflächen selbst verlegen.

Eine weitere Möglichkeit, Leiterbilder unabhängig von Bildaufnahmeflächen zu verlegen, besteht darin, in der Halbleiterscheibe in Form entartet dotierter, vergrabener Zonen elektrische Leiter vorzusehen. Alle diese Leiter und Leiterbilder dienen zum Betreiben, Ansteuern, sowie Adressieren der sich auf der Halbleiterscheibe 2 befindenden Halbleiter-Bildaufnehmer 1, wobei noch ein zusätzliches Leiterbild zur Entnahme der Videosignale vorgesehen werden muß.

Die Halbleiterscheibe 2 läßt sich mittels an sich bekannter Verfahren auf das Substrat 30 anbringen, wie es dem bereits genannten Buch "Microelectronics Interconnection and Packaging" auf den Seiten 173 bis 206 zu entnehmen ist.

Die Halbleiter-Bildaufnehmer bestehen aus Sensormatrizen, gebildet aus zweidimensionalen Schaltungselementanordnungen, denen als Horizontal- und Vertikalabtaster Schieberegister zugeordnet sind, wobei die Videosignale serienweise über einen Abtastverstärker 26 ausgegeben werden. Die Horizontal- und Vertikalabtaster bestehen je nach Art der in ihrer jeweiligen Matrix verwendeten photoelektronischen Schaltungselementen entweder aus einem einzigen Horizontal und einem einzigen Vertikal-Schieberegister für die Sensormatrix, wie bei Photodioden- sowie Phototransistoren und bei CID-Sensormatrizen, oder aus jeder Sensorspalte oder jeder Sensorzeile zugeordneten und ggf. gegen Lichteinfall geschützten Schieberegistern, die dann über Ausgabeschieberegister und einen gemeinsamen Ausgangsverstärker aufeinanderfolgend serienweise auslesbar sind, wie es bei Anwenden von CCD- und Eimerkettenschaltungen der Fall ist. Eine anschauliche Zusammenstellung hierüber läßt sich dem bereits genannten Buch "Charge Transfer Devices" aus der Serie "Advances in Electronics and Electron Physics, Supplement 8" von Séquin und Tompsett, erschienen in Academic Press Inc., 1975, auf den Seiten 152 bis 157, entnehmen.

Der hiermit beschriebene elektronische Bauteil 51 wird ergänzt durch den nachfolgend beschriebenen optischen Bauteil 50, die beide zusammen in einer das Fernsehkamera-Gehäuse darstellenden Hülse 32 untergebracht sind.

Während gemäß Fig. 1 die jeweilige Verbindung der Anschlußflächen 35 auf der Halbleiterscheibe 2 mit entsprechenden Anschlußflächen auf Substrat 30 über Leiterbrücken 36 vorgenommen ist, sind die Verbindungsleitungen im Ausführungsbeispiel nach Fig. 6 derart angebracht, daß die Anschlußflächen auf Substrat 30 über leitende V-Nuten im Halbleiterscheibenrand verlaufend mit den Anschlußflächen 35 auf der Halbleiterscheibe 2 in Verbindung stehen. Welche Verbindungsart jeweils Verwendung findet, dürfte im wesentlichen davon abhängen, ob die Halbleiterscheibe 2 in das Substrat 30 wie in Fig. 1 eingelassen ist oder aber wie in Fig. 6 auf dem Substrat 30 aufliegt.

Die Substrat-Kontaktteile 33 und 37 können, falls erforderlich, auf einem einzigen Substrat gleichzeitig sowohl in Form von Randkontakten 33 als auch in Form von Knopfkontakten oder Anschlußstiften 37 vorgesehen sein, um unter Umständen Anschlußmöglichkeiten zu erleichtern, wobei dann die Verwendung von Mehrschicht-Keramikträgern als Substrat 30 von besonderem Vorteil sein dürfte.

Der optische Bauteil 50 besteht im einzelnen aus einem Lichtschachtrost 10, der im Anschluß an die Halbleiterscheibe 2 angebracht ist und mehrere, jeweils den einzelnen Halbleiter-Bildaufnehmern 1 zugeordnete Lichtschächte 3 enthält, die sich, ausgehend von der Lichteinfallseite, in Richtung auf die Halbleiter-Bildaufnehmer 1 trichterförmig erweitern. Auf dem Lichtschachtrost 10 liegt eine Linsenplatte 7, die als Abbildungsoptiken 8 eine entsprechende Anzahl von Linsen zwischen den Stegen 9 enthält, denen jeweils ein Lichtschacht 3 zugeordnet ist. Die Linsenplatte 7 kann bei geeigneter Ausbildung des Fernsehkamera-Gehäuses 32 hiermit befestigt sein und dadurch in ihrer Lage gehalten werden, jedoch kann zusätzlich noch eine Formschlußverbindung zwischen Lichtschachtrost 10 und Linsenplatte 7 vorgesehen werden, die im vorliegenden Fall als Zapfenverbindung 18 gezeigt ist.

Zur gegenseitigen Lichtabschirmung können entweder der Lichtschachtrost 3 selbst, oder die Stege 9 lichtundurchlässig ausgebildet sein. Die Linsenplatte kann mit hierin eingelegten Linsen versehen sein, oder aber als Ganzes ein einziges Werkstück bilden, das durch Gießen, Pressen und/oder Schleifen hergestellt ist. Glas oder Kunststoff kann hierzu als Material dienen. Es könnte sogar auch der oben beschriebene gesamte optische Bauteil 50 aus nur einem einzigen gepreßten oder gegossenen Werkstück bestehen.

Mit oben beschriebenen Bauteilen liegen bereits alle Voraussetzungen für eine einfache Schwarzweiß-Fernsehkamera vor, die in einfachster Ausführung, wie gesagt, nur aus einer einzigen linearen Anordnung von Halbleiter-Bildaufnehmern 1 in der Halbleiterscheibe 2 zu bestehen braucht. Eine derart einfachste Festkörper-Fernsehkamera dürfte allerdings nur dann von besonderem Vorteil sein, wenn sie selbst als Bauteil in einem größeren Aggregat vorgesehen wird, wo, bedingt durch den Einbau, der Einfall seitlichen Streulichtes auf die Linsenplatte 7 nicht befürchtet zu werden braucht, also eine besondere Gegenlichtblende entfallen kann, und außerdem noch die Schwarzweiß-Bilderfassung den jeweils vorgegebenen Verwendungszwecken vollkommen genügt.

Soll die Festkörper-Fernsehkamera als eigenständiges Gerät Verwendung finden, dann ist durch Vorsehen einer Gegenlichtblende Vorsorge dafür zu treffen, daß seitlich einfallendes Streulicht nicht zu unerwünschten Aufnahmestörungen führen kann. Ein geeignetes Mittel hierzu besteht darin, einen zweiten Lichtschachtrost 4 mit lichtundurchlässigen Wandungen, ggf. wiederum unter Formschlußverbindung auf die Linsenplatte 7 aufzusetzen, dessen Lichtschächte dann dingseitig trichterförmig auseinanderlaufen. Eine geeignete Abdeckung oberhalb der Einfallsöffnungen des zweiten Lichtschachtrosts 4 verhindert störende Staubansammlung auf der Linsenplatte 7.

Zur Realisierung einer Farbfernsehkamera kann allerdings letztgenannte Abdeckung durch Farbfilter 11 ersetzt sein, die entweder in einem besonderen Filterträger 5 untergebracht sind oder aber auch unmittelbar in einen entsprechend geformten oberen Teil des zweiten Lichtschachtrosts 4 (Fig. 6) eingelassen sind. Der Filterträger 5 kann dabei falls erforderlich mit dem Lichtschachtrost 4 in Formschlußverbindung stehen.

Optischer und elektronischer Bauteil 50, 51 lassen sich auf verschiedenste Weise in der Hülse 32 befestigen und ggf. auch vergießen. Schraub- und Stiftverbindungen zum Beispiel seien hierzu nur am Rande vermerkt.

Bei Verwendung einer linearen Anordnung von Halbleiter-Bildaufnehmern 1 in einer Halbleiterscheibe 2 als Farbfernsehkamera bestehen die Farbfilter 11 aus einzelnen Scheiben mit periodisch aufeinanderfolgenden Grundfarben, so daß über Lichtschächte 3 zugeordnete Halbleiter-Bildaufnehmer 1 ebenfalls jeweils einer Grundfarbe zugeordnet sind. Die Ausgangsverstärker von Halbleiter-Bildaufnehmern 1 jeweils gleicher Grundfarbe liegen je an gemeinsamer Ausgabeleitung, die das Videosignal der betreffenden Grundfarbe überträgt.

Da die Festkörper-Fernsehkamera gemäß der Erfindung einen möglichst einfachen Aufbau besitzen soll, wird infolgedessen der Verwendung möglichst unkomplizierter Abbildungsoptiken 8 der Vorzug gegeben, die natürlich entsprechende Linsenfehler aufweisen. Wenn auch die Linsen einer Linsenplatte zur Kompensation von Linsenfehlern asphärisch ausgebildet werden, so bleiben dann doch bei Anwendung als Farbfernsehkamera Farbenfehler von unter Umständen nicht zu vernachlässigender Bedeutung bestehen. Die verschiedensten Maßnahmen lassen sich treffen, um diese Art Fehler weitgehend auszuschalten. Am einfachsten läßt sich dies durchführen, wenn, wie aus der Abbildung nach Fig. 2 ersichtlich, der obere Teil, also der die Linsenplatte 7 tragende Teil, des unteren Lichtschachtrosts 10 mit Ausnehmungen unterschiedlicher Höhe versehen wird, um die Farbfilter 11, 11', 11'' von je nach Grundfarbe unterschiedlicher Stärke mit Bereitstellung einer der Linsenplatte 7 zugewandten, ebenen Fläche bereitzustellen. Wie ersichtlich, ist der Lichtschachtrost 10 zudem noch so ausgeführt, daß die Seitenwandungen nicht ganz bis zur Halbleiteroberfläche reichen können. Die hierdurch bedingten Schlitze am unteren Rand können unbeachtlich für die Unterbindung gegenseitiger Streubelichtung je benachbarter Halbleiter-Bildaufnehmer 1 sein, jedoch wird hierdurch erreicht, daß die Halbleiteroberfläche von schädlichen Druckauswirkungen verschont bleibt. Die unterschiedliche Dicke der Farbfilter führt zu je entsprechend unterschiedlicher Bildlage in Bezug auf die Höhe, so daß alle Abbildungen in den Grundfarben in gemeinsamer Bildebene, die durch die ebene Halbleiteroberfläche dargestellt wird, zu liegen kommen.

Weitere Möglichkeiten zur Kompensation der Farbabweichung des Bildortes bestehen darin, für die verschiedenen Grundfarben den Abstand zwischen Aufnahmeoptiken 8 und Halbleiter-Bildaufnehmeroberflächen unterschiedlich zu halten In diesem Falle werden, wie in den Fign. 1 und 6 gezeigt, die Farbfilter 11 auf der Dingseite der Abbildungsoptiken 8 angebracht. Der jeweils erforderliche Relativabstand läßt sich dadurch herbeiführen, daß entweder, wie in Fig. 1 gezeigt, die betreffenden Halbleiteroberflächen der den Grundfarben zugeordneten Halbleiter-Bildaufnehmer 1 in entsprechend unterschiedlicher Höhe zu liegen kommen oder aber daß die in Linsenplatte 7 vorgesehenen Linsen 8 je nach Grundfarbe hierin in unterschiedlicher Höhe angebracht sind (Fig. 6).

Mit all diesen Maßnahmen ist aber zunächst nur jeweils die Farbabweichung des Bildortes korrigiert, jedoch nicht die zweite Art der Farbabweichung, nämlich die der Bildvergrößerung. Hierzu muß neben oben beschriebener Gestaltung und Bemessung der bildseitigen Lichtstrekken die Bemessung der Aufnahmeflächen der jeweiligen Halbleiter-Bildaufnehmer 1 je nach zugehöriger Grundfarbe ebenfalls entsprechend unterschiedlich vorgesehen werden. So ist bei kurzem Bildabstand die Aufnahmefläche kleiner als bei größerem Bildabstand. Zum Ausgleich hierdurch bedingter Fehler werden die Halbleiter-Bildaufnehmerflächen unter Wahrung der Anzahl jeweils hierin enthaltener Schaltungselemente, also bei jeweils gleicher Anzahl, je nach zugeordneter Grundfarbe entsprechend unterschiedlich ausgelegt. Dadurch, daß jeweils Vorsorge dafür getroffen wird, daß immer die gleiche Anzahl von Schaltungselementen in den einzelnen Halbleiter-Bildaufnehmern 1 enthalten sind, werden zu den vorgesehenen Taktzeiten beim Auslesen die einem jeweiligen Bildpunkt zugehörigen, den verschiedenen Grundfarben zugeordneten Videosignale immer gleichzeitig über die betreffenden Ausgabeleitungen 22, 23 und 24 übertragen. Beim zu erreichenden Integrationsgrad auf einer Halbleiterscheibe 2 dürfte diese Maßnahme zum Ausgleich der Farbabweichung der Bildvergrößerung keine besonderen Schwierigkeiten bedingen.

Während bei Verwenden unterschiedlicher Dikken der Farbfilter das Farbfilter 11 für die Grundfarbe rot am dicksten und das Farbfilter 11'' für die Grundfarbe blau am dünnsten ist, ist bei Verwenden unterschiedlicher Lichtstreckenbemessungen für jeweils rote Lichtstrecken der Abstand zwischen Linse und Halbleiteroberfläche am geringsten, wohingegen für blaue Lichtstrekken der Abstand zwischen Linse und betreffender Halbleiteroberfläche am größten ist.

Wie bereits gesagt, lassen sich alle Bauelemente des optischen Bauteils 51 zwecks präziser Ausrichtung zueinander über Formschlußverbindungen, wie Nut-Feder-Verbindung, Zapfenverbindung usw. aufeinanderlegen, um dann in Hülse 32 zusammengehalten zu werden.

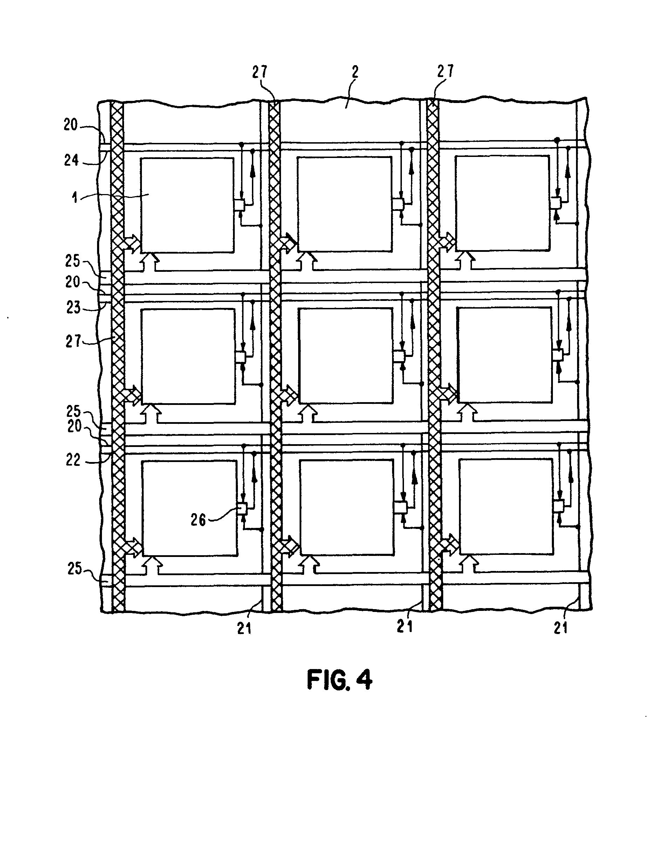

Ist bisher von einer linearen Anordnung der Halbleiter-Bildaufnehmer 1 auf der Halbleiterscheibe 2 ausgegangen worden, so sind bei Anwenden von zweidimensionalen Anordnungen der Halbleiter-Bildaufnehmer 1 auf der Halbleiterscheibe 2 entsprechende Abwandlungen sowohl im optischen Bauteil 50 als auch im elektronischen Bauteil 51 vorzusehen. So besteht die zweidimensionale Anordnung (Fig. 4) gewissermaßen aus nebeneinanderliegenden linearen Anordnungen der Halbleiter-Bildaufnehmer 1, wobei die Videoausgangsleitungen 22, 23 und 24 die Videofarbsignale aller von den den verschiedenen Grundfarben zugeordneten Halbleiter-Bildaufnehmern 1 gesammelt auf die betreffenden Substrat-Kontaktteile 33 und/oder 37 übertragen. Jedenfalls werden sich länglich erstreckende Farbfilter 11, die jeweils eine einer Grundfarbe zugeordneten Zeile (Fig. 4) überdecken, im Farbfilterträger 5 angebracht oder als Farbfilter 11, 11', 11'' unmittelbar in den oberen Teil des jeweils betreffenden Lichtschachtrostes 4 oder 10 eingelegt. Befindet sich die Farbfilteranordnung im oberen Lichtschachtrost 4, dann kann sie gleichzeitig auch als Abdeckung zum Verhindern des Staubbefalls der betreffenden Linsenplatte dienen.

Eine ganz andere Möglichkeit zum Unterdrükken des Farbfehlers unter entsprechender Bemessung und Gestaltung der Lichtstrecken besteht darin, Farbfilter mit gegenüber den Linsen inverser Dispersion zu verwenden. Damit lassen sich gleichzeitig Farbabweichungen des Bildortes und Farbabweichungen der Bildvergrößerung, ohne weitere Maßnahmen zu treffen, beheben.

Für manche Anwendungszwecke kann es vorteilhaft sein, wenn eine Grobregelung der auf die Halbleiteroberfläche einwirkenden Lichtstärke vorgesehen wird. Hierzu bieten sich zwei Möglichkeiten an, nämlich einmal eine dingseitige Abdeckung der Festkörper-Fernsehkamera mit einer photochromen oder phototropen Platte anzubringen, oder aber zum anderen eine ein elektrochromes Medium aufweisende Plattenstruktur dingseitig im optischen Bauteil 50 zu befestigen. Unter dem Begriff elektrochrom soll hier auch elektrochemisch verstanden sein, da eine enge Verwandtschaft der zugrundeliegenden Prozesse vorliegt; jedenfalls aber eine Eintrübung des Mediums unter Feldeinwirkung zu verzeichnen ist. Zweckmäßigerweise liegen derartige Anordnungen zur Regelung der Einfallslichtstärken oberhalb von Farbfiltern oder im oberen Teil des oberen Lichtschachtrosts 4, um so gleichzeitig als Staubabdeckung dienen zu können. Während bei Anwenden eines phototropen und photochromen Mediums automatisch eine Lichtabschwächung in Abhängigkeit von der Lichtstärke des einfallenden Lichtes erfolgt, ist die Lichtabschwächung in elektrochromem Medium abhängig von der hieran liegenden elektrischen Spannung bzw. Feldstärke. Zur Zuführung einer Regel bzw. Steuerspannung an das so angewendete elektrochrome Medium können Zuleitungen dienen, die entweder an oder in der Hülse 32 oder aber über entsprechende Wandungen des Lichtschachtrosts bzw. der Lichtschachtroste bis zu den betreffenden Substrat-Kontaktteilen 33 oder 37 verlaufen. Mittels der hieran angeschlossenen Steuereinheit läßt sich wie bekannt das anzulegende elektrische Feld regeln bzw. einstellen und damit die auf die Halbleiteroberflächenbereiche einfallende Lichtstärke.

Fig. 1 läßt erkennen, in welcher Weise der optische Bauteil 50 und der elektronische Bauteil 51 sich in Hülse 32 anbringen und auch befestigen lassen. Die photochrome oder elektrochrome Struktur 6 liegt direkt an einen Innenflansch der Hülse 32 an, die anschließend aufeinanderfolgend den Filterträger 5, den oberen Lichtschachtrost 4, die Linsenplatte 7, den unteren Lichtschachtrost 10 sowie das Substrat 30 aufnimmt, um hierin durch Verschrauben, Verstiften usw. leicht befestigt werden zu können.

Die der Fig. 1 weiterhin entnehmbare Formschlußverbindung, mittels Zapfenverbindung 18 zwischen unterem Lichtschachtrost 10, Linsenplatte 7, oberem Lichtschachtrost 4 und Filterträger 5 kann auch entfallen, wenn nur eine präzise Aufeinanderfolge der genannten Bauelemente durch Einpassen in Hülse 32 gewährleistet ist.

Wie ersichtlich und bereits erwähnt, können sich die Halbleiter-Bildaufnehmer 1 je nach zugeordneter Grundfarbe in unterschiedlichen Ebenen innerhalb der Halbleiterscheibe 2 befinden. Wenn berücksichtigt wird, daß der Höhenunterschied dieser Halbleiteroberflächen größenordnungsmäßig bei 1% mit Bezug auf die Bildweite liegt, dann dürfte auch hierdurch keine besondere Erschwernis bei Halbleiterherstellung bedingt sein.

Bisher ist eine Festkörper-Fernsehkamera beschrieben, deren Abbildungsoptiken 8 jeweils nur durch eine Linse dargestellt sind. Für einfache Ansprüche kann dies vollauf genügen, da ja wie bereits erwähnt jede Linse nur einen Farbbereich zu übertragen braucht und geometrische Verzeichnung im allgemeinen toleriert werden kann; wobei hinzu kommt, daß die Linsen asphärisch ausgebildet werden können, so daß ausgezeichnete Bilder zu erhalten sind. Für höchste Ansprüche jedoch müssen die Abbildungsoptiken mehrlinsig ausgebildet sein, um die Linsen- bzw. Bildfehler möglichst vollständig korrigieren zu können. Hierzu lassen sich mehrere Linsenplatten mittels entsprechender Formschlußverbindungen übereinanderstapeln (Fig. 3).

Aus der genannten Zeichnung läßt sich entnehmen, in welcher Weise ein derartiges Abbildungsoptik-Feld, mit Cookeschen Objektiven z. B., zu realisieren ist. Die obere Linsenplatte 12 enthält im wesentlichen plankonvexe Linsen 15, die mittlere Linsenplatte 13 enthält Konkav-Konkav-Linsen 16 und die untere Linsenplatte 14 enthält Konvex-Konvex-Linsen 17, welche in den jeweiligen Linsenplatten zwischen den Stegen 9 liegen. Auch hier wiederum können entweder einzelne Linsen in die Linsenplatten eingelegt sein oder mit der jeweiligen Linsenplatte 12, 13, 14 aus je einem einzigen Werkstück bestehen, das wie bereits oben beschrieben, durch Gießen, Pressen und/oder Schleifen entsprechend bearbeitet ist.

Zur jeweiligen Formschlußverbindung ist hier jeweils eine Nut-Feder-Verbindung 19 angedeutet, die das Einhalten präziser Lagen zueinander gewährleistet. Eine derartige Abbildungsoptik-Anordnung liegt zur Realisierung einer entsprechenden Festkörper-Fernsehkamera zwischen oberem Lichtschachtrost 4 und unterem Lichtschachtrost 10, und zwar ebenfalls jeweils wieder über Nut-Feder-Verbindung 19. Eine allenfalls noch als erforderlich angesehene weitergehende Farbfehlerkorrektur läßt sich im übrigen mittels oben beschriebener Maßnahmen vornehmen. Der obere Lichtschachtrost 4 kann mit der oberen Linsenplatte 12 und der untere Lichtschachtrost 10 mit der unteren Linsenplatte 14 je ein Werkstück bilden, das jeweils durch Gießen, Pressen und/oder Schleifen hergestellt ist, wobei natürlich auch hier die Linsen gesondert eingelegt sein können oder, wie gesagt, jeweils ein Werkstück mit der betreffenden Linsenplatte bilden.

Da Ansteuern sowie Betreiben von zweidimensionalen Halbleiter-Bildaufnehmern 1 weitgehend bekannt ist, soll hierauf ebensowenig näher eingegangen werden, wie auf das Herstellen von Halbleiterscheiben 2 mit hierin eingebrachten Halbleiter-Bildaufnehmern 1. Zum Auslesen der Bildpunktinformationen aus den in den Halbleiter-Bildaufnehmern 1 matrixförmig angeordneten Bildsensoren dienen allgemein horizontale Schieberegister die im Ansprechen auf Taktsignale in Form eines Taktpulses die Zeileninformation auf den Ausgangsverstärker 26 übertragen, und vertikale Schieberegister, die aufeinanderfolgend die Zeilenabtastung übernehmen. Dies geschieht im vorliegenden Fall über Betriebsleitungen zur Übertragung der erforderlichen Taktpulse, welche in den Sammelleitungen 25 und 27 (Fig. 4) enthalten sind. Zusätzlich enthalten diese Sammelleitungen 25 und 27 noch Taktpuls-Steuerleitungen zur koordinatenmäßigen Ansteuerung eines jeweiligen Halbleiter-Bildaufnehmers 1, um jeweils wahlweise Horizontal- und/oder Vertikalabtastungseinsatz jedes beliebigen Halbleiter-Bildaufnehmers 1 in der Halbleiterscheibe 2 mit gewünschter Zeile und/oder Spalte auslösen zu können. Eine derartige Auslösung erfolgt mittels Steuersignalen, die von einer an die betreffenden Substrat-Kontaktteile 33 oder 37 angeschlossenen Steuereinheit geliefert werden, da ja die Sammelleitungen 25 und 27 über entsprechende Anschlußflächen 35 auf der Halbleiterscheibe 2 mit den betreffenden Substrat-Kontaktteilen 33 und 37 in Verbindung stehen.

Dank dieser Steuerungsmöglichkeit läßt sich in einfacher Weise mit der erfindungsgemäßen Festkörper-Fernsehkamera ein "unechter" Zoom-Effekt herbeiführen, indem auf allen Halbleiter-Bildaufnehmern die Horizontal- und/oder Vertikalabtastung nicht mit jeweils erster Spalte und/oder Zeile, sondern zeilen- und/oder spaltenversetzt durchgeführt wird. Bei einem derartigen Vorgehen stehen zwar dann für jede Bildaufnahmefläche entsprechend weniger Schaltungselemente zur Verfügung, für die Bildschärfe als solche jedoch kann der damit verbundene geringfügige Nachteil nicht so sehr ins Gewicht fallen, wenn nur eine entsprechend große Anzahl von Schaltungselementen in den einzelnen Halbleiter-Bildaufnehmern 1 vorgesehen wird.

Da die Festkörper-Fernsehkamera gemäß der Erfindung unter Verwenden eines Fixfokussystems aufgebaut ist, können sich unter Umständen Fokussierungsfehler ergeben, die bei höchsten Ansprüchen an die Kamera nicht mehr zu tolerieren sind. Objekte mit gegenüber der Unendlich-Einstellung nicht mehr vernachlässigbarer Entfernung zur Kamera führen bekanntlich zu einem entsprechenden seitlichen Abwandern des durch die Abbildungsoptiken 8 auf der Halbleiteroberfläche jeweils projizierten Brennpunktes. D.h. für derartige Fälle ergibt sich eine gewissermaßen von der Zentrallage des jeweiligen Halbleiter-Bildaufnehmers 1 verschobene Bildfläche. Dieser Tatsache läßt sich Rechnung tragen, wenn nur derjenige Oberflächenbereich des jeweiligen Halbleiter-Bildaufnehmers 1 horizontal und vertikal abgetastet wird, welcher bei Brennpunktabwanderung tatsächlich durch die Abbildungsoptik 8 ausgeleuchtet werden kann, so daß auch in solchen Fällen bei gleichen Taktzeiten von allen Halbleiter-Bildaufnehmern 1 der Halbleiterscheibe 2 gleichartige Videosignale, also gleichen Bildpunkten entsprechend, vorliegen. Die genannte Brennpunktabwanderung nimmt bei gegenüber der Unendlich-Einstellung nicht mehr vernachlässigbar nahem Dingabstand und bei ausgehend von der Zentrallage der Halbleiter-Bildaufnehmer 1 auf der Halbleiterscheibe 2 mehr und mehr zu ihrem Rand hin verschobenen Halbleiter-Bildaufnehmern 1 stetig zu, so daß ein entsprechender Verlust an Bildaufnahmefläche jedes betroffenen Halbleiter-Bildaufnehmers 1 unter Anwenden versetzter Horizonta- lund Vertikalabtastung bewußt in Kauf genommen wird, was aber, wie gesagt, im allgemeinen dank des zu erzielenden Integrationsgrads nicht untragbar ist.

Des weiteren läßt sich mit Hilfe der Festkörper-Fernsehkamera gemäß der Erfindung bei entsprechender Auslegung des elektronischen Bauteils 51 und speziell der Halbleiterscheibe 2 in einfacher Weise auch die Funktion einer Irisblende durchführen. Hierzu muß nur Vorsorge dafür getroffen werden, daß von den auf der Halbleiterscheibe 2 angeordneten Halbleiter-Bildaufnehmern 1 gruppenweise Halbleiter-Bildaufnehmer 1 für die Abgabe von Videoausgangssignalen über die Videoausgangsleitungen 22, 23, 24 ab- und zugeschaltet werden können. Zu diesem Zweck sind die jeweiligen Ausgangsverstärker 26 der einzelnen Halbleiter-Bildaufnehmer 1 als Schaltglieder ausgebildet. Im Übersichtsplan nach Fig. 4 ist zwar jeweils hierfür ein besonderer Flächenbereich auf der Halbleiteroberfläche angedeutet, jedoch nur aus rein zeichnerischen Gründen. In Wirklichkeit ist der für den Ausgangsverstärker vorgesehene Flächenbereich in den jeweiligen Halbleiter-Bildaufnehmer 1 wie bekannt integriert.

Die jeweils als Schaltglied ausgebildeten Ausgangsverstärker 26 gestatten eine koordinatenmäßige Ansteuerung jedes Ausgangsverstärkers 26 über die Ausgabesteuerleitungen 20, 21. Nur wenn beide hierzu vorgesehenen Schaltvariablen an den Steuereingängen dieser Ausgangsverstärker 26 vorliegen, werden jeweils Ausgangssignale auf die Videoausgangsleitungen 23, 24 und 25 von den betreffenden Halbleiter-Bildaufnehmern 1 übertragen. Auf diese Weise läßt sich über die an die Substrat-Kontaktteile 33 oder 37 angeschlossene Steuereinheit der jeweils anteilige Beitrag der Halbleiter-Bildaufnehmer 1 zur Bereitstellung der Videosignale in einfacher Weise steuern, und damit die Funktion einer Irisblende ausführen.

Um Parallaxfehler auszuschalten, werden die Halbleiter-Bildaufnehmer 1 unter optimaler Ausnutzung eines zur Verfügung stehenden Kreisflächenbereichs in eine Halbleiterscheibe 2 eingebracht (Fig. 5). Berücksichtigt werden muß dabei, daß noch entsprechender Platzbedarf für die Anschlußflächen 35 am Rand der kreisförmigen Halbleiterscheibe 2 und zwischen den einzelnen Halbleiter-Bildaufnehmern 1 für die Steuer-Betriebs- und Taktleitungen einzuplanen ist. Im obengenannten Buch betreffend der VLSI-Technik lassen sich genügend Beispiele für optimale Ausnutzung von Halbleiteroberflächen hinsichtlich hierin einzubringender monolithisch integrierter Halbleiterschaltungen finden, so daß auch an dieser Stelle hierauf nicht näher eingegangen zu werden braucht.

Sollten die bisher angegebenen Maßnahmen zum Ausgleich von Linsenfehlern für höchste an die Kamera zu stellende Ansprüche noch nicht ausreichend sein, so lassen sich geometrische Verzerrungsfehler durch entsprechende Auslegung der einzelnen Halbleiter-Bildaufnehmer 1 auf der Halbleiterscheibe hinsichtlich der hierin enthaltenen Schaltungselementanordnung beheben. Als geometrische Linsenfehler liegen sogenannte Kissen- und Tonnenverzerrungen vor. Dementsprechend müßten dann in jedem Halbleiter-Bildaufnehmer 1 die Schaltungselemente längs entsprechend der gewünschten Kompensation gekrümmter, Koordinaten eingebracht werden, also für Tonnenverzerrungen längs Koordinaten, die eine kissenförmige Auslegung der betreffenden Halbleiter-Bildaufnehmer herbeiführen und umgekehrt.

An dieser Stelle sei hervorgehoben, daß die Zeichnungen weder maßstäblich sind noch hinsichtlich dargestellter Bau- und Schaltungselemente anzahlmäßig eine getreue Wiedergabe bieten. So ist die Anzahl der in Fig. 5 gezeigten Anschlußflächen 35 sowie der in Fig. 6 gezeigten Anschlußstifte 37 nicht der Wirklichkeit entsprechend, sondern lediglich der besseren Anschaulichkeit halber gewählt.

Fig 6 zeigt ein einfaches Ausführungsbeispiel der Festkörper-Farbfernsehkamera gemäß der Erfindung, die zum Erzielen zufriedenstellender Ergebnisse alle Voraussetzungen mit sich bringt. Wie bereits erwähnt, besteht der elektronische Bauteil 51 aus einem Mehrschicht-Keramikträger als Substrat 30, in dem die Anschlußstifte 37 eingelassen sind. Das Substrat 30 trägt eine hierauf aufgebrachte Halbleiterscheibe 2, auf der der optische Bauteil 50 ruht. Die Anschlußflächen 35 der Halbleiterscheibe 2 sind, wie bereits gesagt, über leitende V-Nuten am Rand der Halbleiterscheibe 2 mit entsprechenden Anschlußflächen 38 auf dem Substrat 30 verbunden. Der optische Bauteil 50 enthält ein Werkstück, das aus dem oberen Lichtschachtrost 4, der Linsenplatte 7 mit den hierin eingelassenen, als Abbildungsoptiken 8 dienenden Linsen, und dem unteren Lichtschachtrost 10 besteht. Auch dieses Werkstück läßt sich, wie gesagt, entweder mittels Gießen, Pressen und/ oder Zurechtschleifen in entsprechender Form bereitstellen oder durch je besonderes Einlegen der Linsen in die Linsenplatte 7 herstellen. Die Linsen sind auch hier asphärisch ausgebildet.

Alternativ könnte natürlich auch, insbesondere bei Verwenden mehrerer Linsenplatten, zusammen mit dem jeweils anliegenden Lichtschachtrost ein einziges Werkstück gebildet sein. Die Wandungen der Lichtschachtroste und/oder die Stege 9 sind undurchsichtig ausgebildet, so daß eine wirksame Lichtabschirmung gegenüber benachbarten Lichtschächten vorliegt. Werden gesonderte Linsenplatten verwendet, dann genügt es auch, wenn nur die Stege 9 zwischen den Linsen lichtundurchsichtig ausgebildet sind. In jedem Fall aber können Lichtschachtrost und Linsenplatte 7 aus gleichem oder verschiedenem Material, wie Glas oder Kunststoff, bestehen.

Der obere Lichtschachtrost 4 in der Anordnung nach Fig. 6 ist zur Aufnahme von sich senkrecht zur Papierebene länglich erstreckenden Farbfiltern 11 mit periodisch wechselnden Grundfarben vorgesehen. Oberhalb der Farbfilter 11 liegt dann noch eine Plattenstruktur mit elektrochromem Medium, die an über den Außenwandungen der Lichtschachtroste 4 und 10 verlaufenden, hier nicht gezeigten Leitern angeschlossen sind, die über Verbindungen über dem Halbleiterscheibenrand ebenfalls mit betreffenden Substrat-Kontaktteilen 37 in Verbindung stehen. Auf diese Weise läßt sich eine elektronische Regelung der auf der Halbleiterscheibe 2 wirksamen Lichtintensität mittels angeschlossener Steuereinheit vornehmen.

Die Hülse 32 besitzt einen abgestuften Innenflansch 34, der zur Halterung des optischen Bauteils 50 der Festkörper-Farbfernsehkamera dient. Das Substrat 30 ist in an sich bekannter Weise unter Andrücken des optischen Bauteils 50 an die betreffende Ausnehmung des Innenflanschs 34 mit der Hülse 32 fest verbunden, wobei auch hier der untere Lichtschachtrost 10 die Halbleiteroberfläche im Bereich der Halbleiter-Bildaufnehmer 1 nicht berührt.

Die zur Betätigung der Festkörper-Farbfernsehkamera vorgesehene Steuereinheit läßt sich entweder über einen entsprechenden Kabelanschluß an die Substrat-Kontaktteile 37 oder über eine unmittelbar auf das elektronische Bauteil 51 aufgesetzte Steuereinheit, die zudem noch die erforderlichen Stromversorgungs-Baueinheiten enthält, betätigen. Steuereinheit mit Stromversorgungseinheiten kann zwecks Vervollständigung der Festkörper-Farbfernsehkamera gemäß der Erfindung zur Videokamera Teil eines Videosystems sein, das mit entsprechenden Speichereinheiten zur Videospeicherung ausgestattet ist. Hierzu bieten sich die verschiedensten Möglichkeiten an, auf die aber nicht näher eingegangen werden soll.

Im übrigen kann es für manche Anwendungszwecke vorteilhaft sein, dingseitig oberhalb des optischen Bauteils 50 eine Konverteroptik, nämlich Weitwinkelobjektiv oder langbrennweitiges Objektiv, anzubringen. Dies kann entweder auf die Hülse 32 unmittelbar mittels Schraub- oder Bajonettverbindung aufsetzbar sein, oder bei Einbau der Festkörper-Fernsehkamera in ein größeres Aggregat hierüber einschwenkbar angebracht werden. Verschiedene Möglichkeiten sind hier je nach Anwendung denkbar.

**Patentansprüche**

1. Festkörper-Fernsehkamera mit Halbleiter-Bildaufnehmern, die

über je eine Abbildungsoptik fester Brennweite belichtet werden,

jeweils aus einer monolithisch integrierten Mikroschaltung bestehen, die Horizontal- und Vertikalabtastung sowie Ausgangsverstärker (26) enthält,

substratgebunden und über Anschlußflächen (35) der Mikroschaltung mit Substrat-Kontaktteilen (33 oder 37) verbunden sind und

denen zur Horizontal- sowie Vertikalabtastung jeweils über weitere, mit entsprechenden Substrat-Kontaktteilen (33 oder 37) verbundene Anschlußflächen (35) Taktpulse zuführbar sind, dadurch gekennzeichnet,

daß die Halbleiter-Bildaufnehmer (1)

— zum Bereitstellen einer linearen Anordnung, die größenordnungsgsmäßig zehn Halbleiter-Bildaufnehmer (1) enthält, nebeneinanderliegend

— oder zum Bereitstellen einer zweidimensionalen Anordnung in Form mehrerer untereinanderliegender linearer Anordnungen

in einer einzigen Halbleiterscheibe (2) zwecks Bildens eines elektronischen Bauteils (51) eingegliedert sind;

daß die Steuereingänge der Ausgangsverstärker (26) über Ausgabe-Steuerleitungen (20, 21), die mit betreffenden Substrat-Kontaktteilen (33 oder 37) verbunden sind, wahlweise ansteuerbar sind;

daß die Horizontal- und Vertikalabtaster über Taktpuls-Steuerleitungen, die mit betreffenden Substrat-Kontakteilen (33 oder 37) verbunden sind, wahlweise ansteuerbar sind;

daß zwecks gegenseitiger Lichtabschirmung benachbarter Strahlengänge jeder Abbildungsoptik (8) ein Lichtschacht (3) zugeordnet ist, der sich wenigstens zwischen ihr und dem zugeordneten Halbleiter-Bildaufnehmer erstreckt, und

daß ein aus allen Abbildungsoptiken (8) und allen Lichtschächten (3) gebildeter optischer Bauteil (50) zusammen mit dem elektronischen Bauteil (51), und zwar hierauf liegend, in einem Kameragehäuse befestigt ist.

2. Festkörper-Fernsehkamera nach Anspruch 1 dadurch gekennzeichnet, daß zumindest eine die Abbildungsoptiken (8), deren jeweiliger Bildabstand gegenüber dem Dingabstand vernachlässigbar ist, als Fixfokus-Rasteroptik tragende Linsenplatte (z. B. 7), deren hierin enthaltene Linsen durch Stege (9) voneinander getrennt und hiervon gehalten sind, vermittels eines an den Stegen (9) anliegenden, zumindest teilweise die Lichtschächte (3) bildenden Lichtschachtrostes (10), in durch den Bildabstand vorgegebener Entfernung von der Halbleiterscheibe (2) angebracht ist.

3. Festkörper-Fernsehkamera mindestens nach Anspruch 1 dadurch gekennzeichnet, daß bei periodisch aufeinanderfolgender Zuordnung der Grundfarben zu den einzelnen Halbleiter-Bildaufnehmern (1) mittels entsprechenden Einbaus von Farbfiltern (z. B. 11) in den optischen Bauteil (50), deren Farbfehler durch kompensatorische Bemessung bzw. Gestaltung sowohl der für die jeweilige Grundfarbe vorgesehenen Lichtstrecken hinsichtlich des Bildortes als auch der für die Grundfarbe vorgesehenen Halbleiter-Bildaufnehmer (1) hinsichtlich der Bildgröße unterdrückt werden, die Videoausgangsleitungen (22, 23, 24) der Ausgangsverstärker (26) nach Grundfarben zusammengefaßt an den betreffenden Substrat-Kontaktteilen (33 oder 37) liegen.

4. Festkörper-Fernsehkamera mindestens nach Anspruch 3 dadurch gekennzeichnet, daß bei zweidimensionaler Anordnung der Halbleiter-Bildaufnehmer (1) in der Halbleiterscheibe (2) die linearen Anordnungen der Halbleiter-Bildaufnehmer (1) periodisch aufeinanderfolgend jeweils einer der Grundfarben zugeordnet sind, indem die betreffenden, sich längs der jeweiligen linearen Anordnung erstreckenden Farbfilter (11, 11', 11''), entweder im oberen Teil eines Lichtschachtrostes (z. B. 10) selbst oder in einem auf einem Lichtschachtrost (z. B. 4) aufliegenden besonderen Farbfilterträger (5) eingelassen sind.

5. Festkörper-Fernsehkamera nach mindestens einem der Ansprüche 1 bis 4 gekennzeichnet durch einen sich von den Abbildungsoptiken (8) dingseitig erstreckenden, nach außen abgedeckten, als Gegenlichtblende wirkenden, Lichtschächte (3) enthaltenden zweiten Lichtschachtrost (4).

6. Festkörper-Fernsehkamera mindestens nach Anspruch 5 dadurch gekennzeichnet, daß die Abdeckung des zweiten Lichtschachtrosts (4) aus der Farbfilterstruktur (5, 11) und/oder einer elektrochromen oder photochromen bzw. phototropen Struktur (6) besteht.

7. Festkörper-Fernsehkamera nach den Ansprüchen 1 bis 6 dadurch gekennzeichnet, daß die mit vorzugsweise asphärisch ausgebildeten Linsen und mit Verbindungselementen zur Formschlußverbindung mit weiteren Bauelementen des optischen Bauteils (50) ausgestattete Linsenplatte (z. B. 7) aus einem einzigen entsprechend gepreßten, gegossenen und/oder geschliffenen Werkstück besteht.

8. Festkörper-Fernsehkamera mindestens nach Anspruch 7 gekennzeichnet durch mehrere übereinanderliegende Linsenplatten (12, 13, 14) zur Bereitstellung mehrlinsiger Abbildungsoptiken (8), jeweils bestehend aus asphärischen Linsen.

9. Festkörper-Fernsehkamera nach den Ansprüchen 7 und 8 dadurch gekennzeichnet, daß bei gleichem Material von Linsenplatte (7 oder 12, 14) und hieran anstoßendem Lichtschachtrost (4 bzw. 10) beide aus einem einzigen Werkstück gebildet sind.

10. Festkörper-Fernsehkamera nach den Ansprüchen 1 bis 6 dadurch gekennzeichnet, daß die mit asphärisch ausgebildeten Linsen ausgestattete Linsenplatte (7) zusammen mit den hieran anstoßenden Lichtschachtrosten (4 und 10) aus einem einzigen entsprechend gegossenen, gepreßten und/oder geschliffenen Werkstück als Bauelement des optischen Bauteils (50) besteht.

11. Festkörper-Fernsehkamera nach den Ansprüchen 7 bis 10 dadurch gekennzeichnet, daß die Stege (9) der Linsenplatten (7, 12, 13 und 14) und/oder die Lichtschachtroste (4, 10) lichtabsorbierend ausgebildet sind.

12. Festkörper-Fernsehkamera nach den Ansprüchen 1 bis 11 dadurch gekennzeichnet, daß zum Herabsetzen des Parallaxfehlers der Fernsehkamera die zweidimensionale Anordnung der Halbleiter-Bildaufnehmer (1) in der Halbleiterscheibe (2) in erster Näherung einen kreisförmigen Umfang besitzt.

13. Festkörper-Fernsehkamera nach den Ansprüchen 1 bis 12 dadurch gekennzeichnet, daß zum Ausgleich geometrischer, wie kissen- und tonnenförmiger Linsenfehler die einzelnen Schaltungselemente der den jeweiligen Halbleiter-Bildaufnehmer (1) bildenden monolithisch integrierten Mikroschaltung längs entsprechend dem gewünschten Verzerrungsfehlerausgleich gekrümmter Koordinaten in die Halbleiterscheibe (2) eingebracht sind.

14. Festkörper-Fernsehkamera nach den Ansprüchen 1 bis 13 dadurch gekennzeichnet, daß jeweils ein erster Steuereingang der als Schaltglieder ausgebildeten Ausgangsverstärker (26) in den linearen Anordnungen der Halbleiter-Bildaufnehmer (1) an der ersten, der jeweiligen linearen Anordnung zugeordneten Ausgabesteuerleitung (20) liegt und die zweiten Steuereingänge der Ausgangsverstärker (26) der linearen Anordnung der Halbleiter-Bildaufnehmer (1) ggf. zusammen mit den Steuereingängen der lagemäßig entsprechenden Ausgangsverstärker (26) in den übrigen linearen Anordnungen der Halbleiter-Bildaufnehmer (1) an je eine zweite Ausgabesteuerleitung (21) angeschlossen sind, so daß durch wahlweises Abschalten einzelner Ausgangsverstärker (26) bzw. Ausgangsverstärkergruppen mittels einer an die betreffenden Substrat-Kontaktteile (33 oder 37) angeschlossenen Steuereinheit die Funktion einer Irisblende durchführbar ist.

15. Festkörper-Fernsehkamera nach den Ansprüchen 1 bis 14 dadurch gekennzeichnet, daß durch koordinatenmäßige Ansteuerung über die mit den Halbleiter-Bildaufnehmern (1) verbundenen Taktpuls-Steuerleitungen in den den Koordinaten der zweidimensionalen Anordnung der Halbleiter-Bildaufnehmer (1) zugeordneten Sammelleitungen (25, 27) mittels der Steuereinheit ein jeweils wahlweise versetzbarer Horizontal- und/oder Vertikalabtastbeginn im hierdurch angesteuerten Halbleiter-Bildaufnehmer (1) bzw. in hierdurch angesteuerten Halbleiter-Bildaufnehmern (1) zwecks Durchführens einer Fokussierungs- und/oder ''unechten'' Zoom-Funktion auslösbar ist.

16. Festkörper-Fernsehkamera nach den Ansprüchen 1 bis 15 dadurch gekennzeichnet, daß ein sich über den optischen Bauteil (50) hinaus erstreckender Teil der Hülse (32) zur Aufnahme einer Konverteroptik eingerichtet ist.

## Revendications

1. Caméra de télévision à semi-conducteurs comportant des capteurs d'images à semi-conducteurs qui

sont exposés chacun au moyen d'un système optique de reproduction de distance focale fixe,

sont constitués chacun par un micro circuit à intégration monolithique qui comprend un système de balayage horizontal et vertical, ainsi que des amplificateurs de sortie (26),

sont fixés au substrat et sont reliés par des surfaces de connexion (35) du micro-circuit à des éléments de contact de substrat (33 ou 37) et à chacun desquels peuvent être transmises des impulsions de rythme par l'intermédiaire d'autres surfaces de connexion (35) reliées à des éléments de contact de substrat (33 ou 37) correspondants, pour le balayage horizontal et vertical, caractérisée en ce que les capteurs d'images à semi-conducteurs (1) sont intégrés
— pour produire un agencement linéaire qui comprend de l'ordre de dix capteurs d'images à semi-conducteurs (1), dans des positions contiguës,
— ou pour produire un agencement bidimensionnel, sous forme de plusieurs agencements linéaires situés les uns au-dessous des autres, dans un disque semi-conducteur unique (2) au fin de constituer un module électronique (51);

en ce que les entrées de commande des amplificateurs de sortie (26) peuvent être attaquées à volonté par l'intermédiaire de conducteurs de commande de sortie (20, 21) qui sont reliés à des éléments de contact de substrat correspondants (33 ou 37);

en ce que les systèmes de balayage horizontal et vertical peuvent être activés à volonté par l'intermédiaire de conducteurs de commande d'impulsions de rythme qui sont reliés à des éléments de contact de substrat (33 ou 37) correspondants;

en ce que, pour un isolement optique mutuel de chemins optiques voisins, il correspond à chaque système optique de reproduction une prise de lumière (3) qui s'étend au moins entre lui et le capteur d'images à semiconducteurs correspondant, et

en ce qu'un module optique (50) constitué par tous les systèmes optiques de reproduction (8) et toutes les prises de lumière (3) est fixé avec le module électronique (51), et cela en étant placé sur lui, dans un boîtier de caméra.

2. Caméra de télévision à semi-conducteurs selon la revendication 1, caractérisée en ce qu'au moins une plaque à lentilles (par exemple 7) portant les systèmes optiques de reproduction (8), dont la distance image de chacun est négligeable par rapport à la distance objet, sous la forme de système optique en réseau à foyer fixe, dont les lentilles qui y sont contenues sont séparées entre elles par des nervures (9) et retenues par celles-ci, est placée au moyen d'une grille de prise de lumière (10) en contact avec les nervures (9), formant au moins partiellement les prises de lumière (3), à une distance du disque semi-conducteur (2) prédéterminée par la distance image.

3. Caméra de télévision à semi-conducteurs au moins selon la revendication 1, caractérisée en ce qu'en cas de rattachement à succession périodique des couleurs de base aux capteurs d'images à semi-conducteurs (1) individuels, au moyen de l'insertion correspondante de filtres chromatiques (par exemple 11) dans le module optique (50), dont les aberrations chromatiques sont supprimées par un dimensionnement ou une conformation compensatrice tant des trajets optiques prévus pour chaque couleur de base en ce qui concerne le lieu d'image que des capteurs d'images à semiconducteurs (1) prévus pour la couleur de base en ce qui concerne la grandeur d'image, les conducteurs de sortie vidéo (22, 23, 24) des amplificateurs de sortie (26) sont placés, groupés selon les couleurs de base, sur les éléments de contact de substrat (33 ou 37) concernés.

4. Caméra de télévision à semi-conducteurs au moins selon la revendication 3, caractérisée en ce que, dans le cas d'un agencement bidimensionnel des capteurs d'images à semi-conducteurs (1) dans le disque semi-conducteur (2), les agencements linéaires des capteurs d'images à semi-conducteurs (1) sont rattachés chacun selon une succession périodique à l'une des couleurs de base, les filtres chromatiques (11, 11', 11'') s'étendant le long de chaque agencement linéaire respectif étant incorporés dans la partie supérieure d'une grille de prises de lumière (par exemple 10) elle-même ou dans un support de filtres chromatiques (5) particulier placé sur une grille de prises de lumière (par exemple 4).

5. Caméra de télévision à semi-conducteurs selon l'une au moins des revendications 1 à 4, caractérisée par une seconde grille de prises de lumière (4) s'étendant côté objet à partir des systèmes optiques de reproduction (8), recouverte vers l'extérieur, contenant des prises de lumière (3), jouant le rôle d'écran opaque.

6. Caméra de télévision à semi-conducteurs au moins selon la revendication 5, caractérisée en ce que le recouvrement de la seconde grille de prises de lumière (4) est constitué par la structure de filtres chromatiques (5, 11) et/ou une structure électrochrome ou photochrome, respectivement phototrope (6).

7. Caméra de télévision à semi-conducteurs selon les revendications 1 à 6, caractérisée en ce que la plaque à lentilles (par exemple 7), pourvue de lentilles de conformation de préférence non-sphérique et d'éléments de liaison pour l'assemblage par concordance de forme avec d'autres composants du module optique (50), est constituée d'une seule pièce moulée, coulée et/ou rectifiée de façon correspondante.

8. Caméra de télévision à semi-conducteurs au moins selon la revendication 7, caractérisée par plusieurs plaques à lentilles superposées (12, 13, 14) pour constituer des systèmes optiques de reproduction à plusieurs lentilles (8), comprenant chacun des lentilles non-sphériques.

9. Caméra de télévision à semi-conducteurs selon les revendications 7 et 8, caractérisée en ce que, dans le cas d'une même matière de la plaque à lentilles (7 ou 12, 14) et de la grille de prises de lumière (4, respectivement 10) qui la contacte, les deux sont formées d'une seule pièce.

10. Caméra de télévision à semi-conducteurs selon les revendications 1 à 6, caractérisée en ce que la plaque à lentilles (7) pourvue de lentilles de conformation non-sphèrique est constituée, avec les grilles de prises de lumière (4 et 10) qui la contactent, d'une seule pièce coulée, moulée et/ou rectifiée de façon correspondante, en tant que composant du module optique (50).

11 Caméra de télévision à semi-conducteurs selon les revendications 7 à 10 caractérisée en ce que les nervures (9) des plaques à lentilles (7, 12, 13 et 14) et/ou les grilles de prises de lumière (4, 10) sont réalisées de façon à absorber la lumière.

12. Caméra de télévision à semi-conducteurs selon les revendications 1 à 11, caractérisée en ce que, pour réduire l'erreur de parallaxe de la caméra de télévision, l'agencement didimensionnel des capteurs d'images à semiconducteurs (1) dans le disque semi-conducteur (2) présente en première approximation un contour circulaire.

13. Caméra de télévision à semi-conducteurs selon les revendications 1 à 12, caractérisée en ce que, pour compenser des aberrations géométriques des lentilles, telles que des distorsions en coussin ou en barillet, les éléments de circuit individuels du micro-circuit à intégration monolithique constituant chaque capteur d'images à semi-conducteurs (1) respectif sont insérés dans le disque semi-conducteur (2) suivant des coordonnées incurvées selon la compensation d'aberration souhaitée.

14. Caméra de télévision à semi-conducteurs selon les revendications 1 à 13, caractérisée en ce que chaque première entrée de commande respective des amplificateurs de sortie (26) conformés en circuits logiques dans les agencements linéaires des capteurs d'images à semi-conducteurs (1) se trouve sur le premier conducteur de commande de sortie (20) correspondant à l'agencement linéaire respectif et les secondes entrées de commande des amplificateurs de sortie (26) de l'agencement linéaire des capteurs d'images à semi-conducteurs (1), éventuellement avec les entrées de commande des amplificateurs de sortie (26) de position correspondante des autres agencements linéaires des capteurs d'images à semi-conducteurs (1), sont reliées chacune à un second conducteur de commande de sortie (21) respectif, de sorte qu'en déconnectant sélectivement des amplificateurs de sortie individuels (26) ou des groupes d'amplificateurs de sortie, on peut réaliser, au moyen d'une unité de commande raccordée aux éléments de contact de substrat (33 ou 37) correspondants, la fonction d'un diaphragme à iris.

15. Caméra de télévision à semi-conducteurs selon les revendications 1 à 14, caractérisée en ce que, par une activation selon les coordonnées par l'intermédiaire de conducteurs de commande d'impulsions de rythme reliés aux capteurs d'images à semi-conducteurs (1) dans les bus (25, 27) correspondant aux coordonnées de l'agencement bidimensionnel de capteurs d'images à semi-conducteurs (1), au moyen de l'unité de commande, on peut déclencher un début de balayage horizontal et/ou vertical chaque fois décalable à volonté dans le capteur d'images à semi-conducteurs (1) ainsi activé ou dans les capteurs d'images à semi-conducteurs (1) ainsi activés, pour réaliser une fonction de focalisation et/ou de "faux" zooming.

16. Caméra de télévision à semi-conducteurs selon les revendications 1 à 15, caractérisée en ce qu'une partie du tube (32) s'étendant au-delà du composant optique (50) est agencée pour recevoir un système optique convertisseur.

**Claims**

1. Solid-state television camera with semiconductor image sensors which
   are exposed via one respective imaging optic of a fixed focal length,
   respectively consist of a monolithically integrated microcircuit comprising horizontal and vertical scanning as well as output amplifiers (26),
   are substrate-tied and connected via contact pads (35) of the microcircuit to substrate contact parts (33 or 37), and
   to which clock pulses are applicable for horizontal as well as vertical scanning, via respective further contact pads (35) connected to corresponding contact parts (33 or 37), characterized in that the semiconductor image sensors (1)
   — for providing a linear array comprising in the order of magnitude ten semiconductor image sensors (1), one beside the other
   — or for providing a two-dimensional array in the form of several linear arrays placed one beneath the other are incorporated in one single semiconductor wafer (2) to form an electronic unit (51);

that the control inputs of the output amplifiers (26) are selectively addressable via output control lines (20, 21) connected to respective substrate contact parts (33 or 37);

that the horizontal and vertical scanners are selectively addressable via clock pulse control lines connected to respective substrate contact parts (33 or 37);

that for the purpose of mutual light shading of adjacent beam paths each imaging optics (8) has an associated light funnel (3) extending at least between the optics and the associated semiconductor image sensor, and

that an optical unit (50) consisting of all imaging optics (8) and all light funnels (3), together with the electronic unit (51) and placed thereon, is mounted in a camera housing.

2. Solid-state television camera as claimed in claim 1, characterized in that at least one lens array (e.g. 7) is provided which carries as fix focus raster optics the imaging optics (8) with an image distance that is negligible compared with the object distance, the lenses of said array being separated from each other by frame walls (9) and also supported thereby, and that said array is mounted by means of a light funnel array (10) placed against the frame walls (9) and at least partly forming the light funnels (3), at a distance from the semiconductor wafer (2) that is predetermined by the image spacing.

3. Solid-state television camera claimed in at least claim 1, characterized in that with periodically successive correlation of the primary colors to the individual semiconductor image sensors (1) by means of the corresponding incorporation of color filters (e.g. 11) in the optical unit (50), whose chromatic defects are suppressed through compensatory dimensioning or structuring of the light paths for the respective primary color with regard to the image position, as well as of the image sensors (1) for the primary color with regard to the image size, the video output lines (22, 23, 24) of the output amplifiers (26) are provided assembled in accordance with the primary colors, at the respective substrate contact parts (33 or 37).

4. Solid-state television camera claimed in at least claim 3, characterized in that with a two-dimensional array of the semiconductor image sensors (1) in the semiconductor wafer (2) the linear arrays of the semiconductor image sensors (1) are associated, in periodical succession, to one respective of the primary colors in that the respective color filters (11, 11', 11'') extending along the respective linear array are inserted either in the upper part of a light funnel array (e.g. 10) itself, or in a specific color filter carrier (5) placed onto a light funnel array (e.g. 4).

5. Solid-state television camera as claimed in at least one of claims 1 to 4, characterized by a second light funnel array (4) extending from the imaging optics (8) on the object side, and being externally covered, and having a sunshade function, and comprising light funnels (3).

6. Solid-state television camera claimed in at least claim 5, characterized in that the cover of the second light funnel array (4) consists of the color filter structure (5, 11) and/or an electrochromic or photochromic or phototropic structure (6).

7. Solid-state television camera as claimed in claims 1 to 6, characterized in that the lens array (e.g. 7) equipped with preferbly aspherical lenses and with connecting elements for the positive connection with further construction elements of the optical unit (50), consists of one single, correspondingly compressed, cast, and/or ground workpiece.

8. Solid state television camera claimed in at least claim 7, characterized by several superimposed lens arrays (12, 13, 13) for providing multi-lens imaging optics (8), each consisting of aspherical lenses.

9. Solid-state television camera as claimed in claims 7 and 8, characterized in that the same material being used for lens array (7 or 12, 14) and adjacent light funnel array (4 or 10) both are shaped of one single workpiece.

10. Solid-state television camera as claimed in claims 1 to 6, characterized in that the lens array (7) with aspherical lenses consists together with the adjacent light funnel arrays (4 and 10) of one single correspondingly cast, compressed, and/or ground workpiece as a structural element of the optical component (50).

11. Solid-state television camera as claimed in any one of claims 7 to 10, characterized in that the frame (9) of the lens arrays (7, 12, 13, and 14) and/or the light funnel arrays (4, 10) are of a light-absorbing material.

12. Solid-state television camera as claimed in claims 1 to 11, characterized in that for reducing the parallax error of the television camera the two-dimensional array of the semiconductor image sensors (1) in the semiconductor wafer (2) has in a first approximation a circular circumference.

13. Solid-state television camera as claimed in any one of claims 1 to 12, characterized in that for compensating geometrical lens defects, as barrel or pincushion distortions, the individual structure elements of the monolithically integrated microcircuits representing the respective semiconductor image sensor (1) are incorporated in the semiconductor wafer (2) along coordinates curved in accordance with the desired distortion error compensation.

14. Solid-state television camera as claimed in any one of claims 1 to 13, characterized in that one respective first control input of the output amplifiers (26) designed as switching circuits is provided in the linear arrays of the semiconductor image sensors (1) at the first output control line (20) associated to the respective linear array, and that the second control inputs of the output amplifiers (26) of the linear array of the semiconductor image sensors (1), possibly together with the control inputs of the output amplifiers (26) corresponding with respect to the position, are connected in the remaining linear arrays of the semiconductor image sensors (1) to one respective second output control line (21), so that by selectively switching off individual output amplifiers (26) or output amplifier groups by means of a control unit connected to the respective substrate contact parts (33 or 37) the function of an iris diaphragm can be implemented.

15. Solid-state television camera as claimed in any one of claims 1 to 14, characterized in that by coordinate-wise addressing via the clock pulse control lines connected to the semiconductor image sensors (1), in the busses (25, 27) associated to the coordinates of the two-dimensional arrangement of the semiconductor image sensors (1), by means of the control unit, a respective selectively staggerable horizontal and/or vertical scanning start in the thus addressed semiconductor image sensor (1), or in semiconductor image sensors (1) addressed thereby can be released for implementing a focussing and/or "phantom" zoom function.

16. Solid-state television camera as claimed in any one of claims 1 to 15, characterized in that a sleeve (32) part extending over the optical unit (50) is provided to receive converter optics.

FIG. 1

FIG. 2

FIG. 3

FIG. 4

FIG. 5

FIG. 6